# EUROPÄISCHE PATENTANMELDUNG

(11) **EP 0 584 867 A2**
(43) Veröffentlichungstag der Anmeldung: **02.03.1994**
(21) Anmeldenummer: 93202412.8
(22) Anmeldetag: 17.08.1993
(51) Int. Cl.: G01R 33/035

(54) **Schaltungsanordnung zum Betrieb eines SQUID's, insbesondere eines DC-SQUID's**

(30) Priorität: 22.08.1992 DE 4227876
(71) Anmelder: Philips Patentverwaltung GmbH, 22335 Hamburg (DE); Philips Electronics N.V., 5621 BA Eindhoven (NL)
(72) Erfinder: Krüger, Johann Emil Wilhelm, D-20097 Hamburg (DE); Dössel, Olaf Helmut, D-20097 Hamburg (DE)
(74) Vertreter: Hartmann, Heinrich, Dipl.-Ing.

(57) **Zusammenfassung**

Schaltungsanordnung zum Betrieb eines SQUID's, insbesondere eines DC-SQUID's (21) mit einer Einkoppelspule (25) in einem bedämpften Meßkreis (26), mindestens einem Widerstand (27), Verbindungsleitungen (19, 20, 23, 24, 34, 35) und Kontaktpads (11, 12, 13, 14, 15, 16) zum Anschluß des SQUID's (21), eines Gradiometers (18) und einer Regelelektronik, wobei die Schaltungsanordnung eine rückwirkungsfreie integrierte Regelkreisschaltung und Sonderfunktionen ermöglicht und gleichzeitig deren Herstellung wesentlich vereinfacht, durch eine erste und eine zweite Verbindungsleitung (34, 35), die zwischen dem Meßkreis (26) und einem ersten und zweiten Kontaktpad (11, 12) zum Anschluß mindestens des Ausgangssignals der Regelelektronik und zum galvanischen Einkoppeln des von dieser bereitgestellten integrierten Reglerstroms vorgesehen sind, wobei das SQUID-Signal als Eingangssignal der Regelelektronik über einen fünften und sechsten Kontaktpad (13, 14) zur Verfügung steht.

## Beschreibung

Die vorliegende Erfindung betrifft eine Schaltungsanordnung zum Betrieb eines SQUID's, insbesondere eines DC-SQUID's mit einer Einkoppelspule in einem bedämpften Meßkreis, mindestens einem Widerstand, Verbindungsleitungen und Kontaktpads zum Anschluß des SQUID's, eines Gradiometers und einer Regelelektronik.

Derartige Schaltungsanordnungen sind bekannt. Beispielsweise ist aus dem Aufsatz "Principles and Applications of SQUID's", J. Clarke, Proc. IEEE Vol. 77 No. 8, p. 1208 (1989), die Anordnung eines DC-SQUID's bekannt, wie sie vorzugsweise für biomagnetische Sensoren üblich ist. Bei dieser Anordnung ist einem SQUID-Ring, bestehend aus einer supraleitenden SQUID-Induktivität mit den Josephson-Kontakten ein Meßkreis zugeordnet. Der Meßkreis enthält eine Einkoppelspule, die letztlich über Verbindungsdrähte mit einem als Meßspule dienenden Gradiometer verbunden ist. Der Meßkreis, bestehend aus der Einkoppelspule mit Verbindungsleitungen und letztlich dem Gradiometer muß supraleitend sein. Ein externes Magnetfeld, bzw. genauer dessen Gradient, verursacht im Gradiometer einen Strom, der letztlich über die Einkoppelspule einen Magnetfluß in dem SQUID-Ring erzeugt. Damit dieser externe Magnetfluß mit möglichst hoher Effizienz in den SQUID-Ring eingekoppelt werden kann, muß die Kopplung zwischen der Einkoppelspule und dem SQUID-Ring so fest wie nur möglich sein. Erreichbar ist ein Koppelfaktor zwischen Einkoppelspule und SQUID-Ring von bis zu 0,9. Zur Bedämpfung parasitärer Effekte, die zur Degenerierung der an sich sinusförmigen SQUID-Kennlinie führen würden, ist im einfachsten Fall der Einkoppelspule ein Widerstand parallelgeschaltet.

Zur Linearisierung des Ausgangssignals und um eine genügend große Meßdynamik zu erzielen, wird ein SQUID in einer sogenannten Flux-Locked-Loop Schaltung betrieben. Gemeint ist eine integrierende Regelkreisschaltung, welche bewirkt, daß der Fluß im SQUID-Ring trotz externer Felder am Punkt der größten Empfindlichkeit verbleibt. Um dies zu erreichen, wird im Stand der Technik der Ausgangsstrom des Reglers als Gegenkopplung in eine dem SQUID-Ring magnetisch zugeordnete Modulationsspule eingespeist. Dieser Strom ist dann gleichzeitig dem zu messenden externen Magnetfeld proportional. Der Koppelfaktor zwischen dieser Modulationsspule und dem SQUID-Ring ist an sich frei wählbar und beträgt typisch 0,5. Das Eingangssignal für die Regelelektronik wird an zwei Kontaktpads (Kontaktpunkten), die über Verbindungsleitungen mit dem SQUID-Ring verbunden sind, entnommen. Gleichzeitig wird in diesen Strompfad ein "Biasstrom" eingespeist, mit welchem der optimale Arbeitspunkt eingestellt werden kann.

Weitere Realisierungen entsprechender Schaltungsanordnungen sind beispielsweise aus dem US-Patent 4 389 612 oder der deutschen Patentanmeldung P 39 26 917 bekannt. Die daraus bekannten Schaltungsanordnungen betreffen eine Realisierung auf Gleichstrombasis oder eine Realisierung mit alternierendem Biasstrom. Auch bei diesen Anwendungen ist an sich ein Modulationsstrom entsprechender Frequenz erforderlich. Er wird dem Reglerstrom überlagert und somit in die Modulationsspule eingespeist.

Am Rande sei hier noch der Abstract JP-A-2-29 8878 erwähnt, der jedoch eine Anordnung betrifft, bei der die Einkoppelspule geöffnet und herausgeführt ist, um zusätzliche Spulen einzufügen. Hierdurch soll der Dynamik-Bereich des Systems vergrößert werden, was jedoch nur bei sogenannten digitalen SQUID's sinnvoll und für die vorliegend betrachteten klassischen SQUID's ohne Bedeutung ist.

Auch bei Anwendungen, wie sie aus dem Aufsatz "Elimination of flux-transformer crosstalk in multichannel SQUID magnetometers", H.J.M ter Brake, F.H. Fleuren, J.A. Ulfman, J. Flokstra, Cryogenics Vol. 26, p. 667-670 (1986), bekannt sind, bei denen absolute Rückwirkungsfreiheit gefordert wird, d.h. bei denen nicht nur der Fluß im SQUID, sondern auch der durch das externe Feld im Gradiometer hervorgerufene Strom zu Null kompensiert werden muß, ist eine induktive Kopplung möglich.

Bei all diesen Anwendungen werden das SQUID (bzw. der SQUID-Ring), die Einkoppelspule und die Modulationsspule etc. oft auf einem einzigen Chip integriert und bilden ein SQUID-Modul. Die Herstellung einer solchen kompletten Schaltungsanordnung ist jedoch ein technologisch schwieriger und aufwendiger Prozeß, wobei jeder zusätzliche Herstellungsschritt die Ausbeute reduzieret. Aus diesem Grund wird die Modulationsspule auch oft separat gefertigt und erst später auf das eigentliche SQUID-Modul montiert. Abgesehen von dem hierzu erforderlichen Aufwand, ergeben sich hierdurch vergrößerte Toleranzen für den Koppelfaktor zwischen dem SQUID-Ring und der Modulationsspule. Da dieser Koppelfaktor jedoch unmittelbar in die Kreisverstärkung des Reglers eingeht, muß bei diesem der Einstellbereich dann entsprechend groß ausgelegt werden.

Ein weiterer im Stand der Technik erforderlicher Herstellungsschritt ist durch die Möglichkeit des Einfrierens des magnetischen Flusses eines SQUID-Moduls bedingt. Es geschieht tatsächlich nämlich nicht selten, daß SQUID's wegen ihrer supraleitenden Strukturen, hervorgerufen durch externe Störungen elektrischer und/oder magnetischer Natur, Magnetflüsse einfrieren, was letztlich zu einer Degenerierung ihrer Kennlinie führt. Abhilfe schafft nur eine Erwärmung, d.h. eine kurzzeitige Überschreitung der Sprungtemperatur der verwendeten supraleitenden Materialien. Aus dem US-Patent 4 689 559 ist es bekannt, in der Nähe des SQUID's (bzw. des SQUID-Rings) einen Heizwiderstand anzubringen, der über zusätzliche Verbindungsleitungen mit verhältnismäßig großen Strom und Spannungswerten versorgt werden muß.

Aufgabe der vorliegenden Erfindung ist es, eine Schaltungsanordnung zum Betrieb eines SQUID's, insbesondere eines DC-SQUID's zu schaffen, die eine rückwirkungsfreie integrierende Regelkreisschaltung und Sonderfunktionen ermöglicht und gleichzeitig einfach aufgebaut ist, wodurch ihre Herstellung wesentlich vereinfacht wird.

Diese Aufgabe wird erfindungsgemäß dadurch gelöst, daß eine erste und eine zweite Verbindungsleitung zwischen dem Meßkreis und einem ersten und zweiten Kontaktpad zum Anschluß mindestens des Ausgangssignals der Regelelektronik und zum galvanischen Einkoppeln des von dieser bereitgestellten integrierten Reglerstroms vorgesehen sind, wobei das SQUID-Signal als Eingangssignal der Regelelektronik über einen fünften und sechsten Kontaktpad zur Verfügung steht.

Weitere bevorzugte Ausgestaltungen der Erfindung ergeben sich aus den Unteransprüchen.

Wie bereits erwähnt, ist es Ziel der Erfindung, eine Schaltungsanordnung zu schaffen, die bestückbar mit einem SQUID und wesentlich einfacher aufgebaut ist, als die im Stand der Technik bekannten und somit die Basis eines kompletten SQUID-Moduls bildet. Die auch verwendete Bezeichnung DC-SQUID ist selbstverständlich nicht darauf beschränkt zu verstehen.

Gegenüber dem Stand der Technik soll erfindungsgemäß der Reglerstrom galvanisch in die Einkoppelspule eingespeist werden. Dies geschieht erfindungsgemäß über eine erste und eine zweite Verbindungsleitung, die einerseits über einen ersten und einen zweiten Kontaktpad mit der Regelelektronik und andererseits mit einer dritten und vierten Verbindungsleitung des Meßkreises galvanisch verbunden sind und somit letztlich auch direkt an der Einkoppelspule angeschlossen sind. Dadurch wird eine im Stand der Technik erforderliche Modulationsspule völlig überflüssig. Die mit der Modulationsspule zusammenhängenden eingangs geschilderten Probleme werden somit erfindungsgemäß überwunden.

Es kann mathematisch gezeigt werden, und es wurde durch Messungen bestätigt, daß das globale Verhalten einer im Stand der Technik bekannten Schaltungsanorndung mit einer Modulationsspule und das der erfindungsgemäßen Schaltungsanordnung mit galvanischer Einkopplung identisch ist. Während sich bei der im Stand der Technik bekannten Schaltungsanordnung mit Modulationsspule die Magnetflüsse der Einkoppelspule und der Modulationsspule im SQUID-Ring zu Null kompensieren, wird in der erfindungsgemäßen Schaltungsanordnung der Strom in der Einkoppelspule zu Null kompensiert und damit auch der Fluß im SQUID-Ring zu Null. Würden in eine erfindungsgemäße Schaltungsanordnung die einzelnen Ströme auf den Verbindungsleitungen eingetragen werden, so würde deutlich werden, daß der Strom in einem Gradiometer durch die erfindungsgemäße Kompensation nicht verschwinden, sondern erhöht werden würde. Weniger durchsichtig ist Tatsache, daß dieser eigentlich unerwünschte Effekt auch in einer Schaltungsanordnung mit Modulationsspule auftritt, da sich bei einem theoretischen Koppelfaktor von 1 der gleiche Zuwachs ergeben würde.

Gemäß einer weiteren erfindungsgemäßen Ausgestaltung kann die Schaltungsanordnung durch eine geringfügige Modifikation auch für Anwendungen genutzt werden, bei denen absolute Rückwirkungsfreiheit gefordert wird, d.h. bei denen nicht nur der Fluß im SQUID, sondern auch der durch das externe Feld im Gradiometer hervorgerufene Strom zu Null kompensiert werden muß. Auch bei diesen Anwendungen ist eine galvanische Einspeisung des Reglerstromes in den Meßkreis möglich und einfacher als eine im Stand der Technik übliche induktive Kopplung. In diesem Fall ist erfindungsgemäß eine zusätzliche superleitende Induktivität im Meßkreis vorgesehen.

Erfindungsgemäß kann diese zusätzliche supraleitende Induktivität in der dritten Verbindungsleitung zum Gradiometer weisend zwischengeschaltet sein. Sie kann sozusagen ein Teilstück der dritten Verbindungsleitung und in dieser zum Gradiometer weisend angeordnet sein. Ihr zum Gradiometer weisendes Ende ist dann mit der ersten Verbindungsleitung und ihr zur Einkoppelspule weisendes Endes mit der zweiten Verbindungsleitung verbunden. Durch Einspeisen des Reglerstroms an den Endpunkten dieser zusätzlichen Induktivität wird der Strom außerhalb der Induktivität kompensiert und in ihr erhöht, bis der gesamte Fluß in der Induktivität konzentriert ist, da die Summe aller Flüsse konstant bleibt. Die Induktivität ist erfindungsgemäß mit den übrigen Induktvitäten des SQUID-Moduls magnetisch nicht verkoppelt.

Gemäß einer weiteren Ausgestaltung der Erfindung kann bei der erfindungsgemäßen Schaltungsanordnung quasi nebenbei und auf herstellungsmäßig einfachste Weise das Einfrieren eines SQUID-Moduls verhindert werden. Hierzu sind zusätzliche Widerstände neben einem ersten Widerstand, der ähnlich wie im Stand der Technik parallel zur Einkoppelspule geschaltet ist, vorgesehen.

Die zusätzlichen Widerstände betreffen zunächst einen zweiten Widerstand, der in einer den ersten und zweiten Kontaktpad verbindenden fünften Verbindungsleitung angeordnet ist und ferner einen dritten und vierten Widerstand, wobei der dritte in der ersten und der vierte in der zweiten Verbindungsleitung angeordnet ist. Der erste Widerstand dient, wie auch im Stand der Technik im wesentlichen der Dämpfung parasitärer Effekte. Die weiteren Widerstände dienen zunächst als Leitungsabschluß, in dem ihr Zusammenwirken in etwa dem Wellenwiderstand der Leitung entspricht.

Entsprechend dem Widerstandsverhältnis des zweiten zum dritten oder vierten Widerstand wird die Reglerstromempfindlichkeit auf ein gewünschtes Maß reduziert. Eine zu feste Kopplung ergibt nämlich eine unerwünscht hohe Empfindlichkeit gegen Hochfrequenz-Fremdeinstrahlung.

Um mögliches Einfrieren des magnetischen Flusses im SQUID der erfindungsgemäßen Schaltungsanordnung bzw. der supraleitenden Materialien zu verhindern und gleichzeitig die Herstellung der erfindungsgemäßen Schaltungsanordnung möglichst einfach zu gestalten, fungieren bei Bedarf der zweite, dritte und vierte Widerstand als Heizwiderstand.

Mit einem nicht näher erläuterten Umschalter, beispielsweise in der Regelelektronik, können die entsprechenden Verbindungsleitungen sozusagen vom Regler-Ausgang abgetrennt und auf eine Heizstromquelle geschaltet werden. Da diese Widerstände erfindungsgemäß örtlich extrem nahe zum SQUID-Ring lokalisiert sind, genügt bereits ein kurzer Heizstromimpuls von angemessenen wenigen Milliampere, wodurch die Doppelfunktion der Widerstände erst möglich wird.

Gemäß einer weiteren erfindungsgemäßen Ausgestaltung kann die Schaltungsanordnung mit den vier Widerständen als Dickfilmschaltung auf einem Keramiksubstrat realisiert werden. Das Keramiksubstrat mißt eine Länge von einigen Zentimetern, eine Breite von wenigen Millimetern und eine Dicke von etwa einem halben Millimeter und dient gleichzeitig als Trägerplättchen für den SQUID-Ring, der quadratisch ausgebildet sein kann mit einer Kantenlänge von weniger als der Breite des Keramiksubstrats und etwa der gleichen Dicke. Erfindungsgemäß wird es zentrisch zu den vier Widerständen montiert. Des weiteren sind erfindungsgemäß in Dickfilmtechnik die Leiterbahnen und Kontaktierungspads, auf dem Trägerplättchen realisiert, auch zum Anschluß des SQUID-Rings, des Gradiometers und der Verbindungsleitungen zur Regelelektronik. Die Einkoppelspule kann ebenfalls direkt auf dem Keramiksubstrat in Dickfilmtechnik realisiert sein. Sie kann aber auch integraler Bestandteil des SQUID-Rings sein, der dann entsprechende Kontakte aufweist, mit denen deren Enden mit dann vorzusehenden weiteren Kontaktpads mit der dritten und vierten Verbindungsleitung verbunden sind. Eine so komplettierte erfindungsgemäße Schaltungsanordnung stellt dann ein komplettes SQUID-Modul dar.

Ausführungsbeispiele der vorliegenden Erfindung werden nachfolgend unter Bezugnahme auf eine Zeichnung näher erläutert. Darin zeigt:
- Fig. 1: eine erfindungsgemäße komplettierte Schaltungsanordnung mit einem daran angeschlossenen Gradiometer,
- Fig. 2: eine erfindungsgemäße Schaltungsanordnung nach Fig. 1 mit zusätzlichen Widerständen,
- Fig. 3: eine erfindungsgemäße Schaltungsanordnung nach Fig. 2 mit einer zusätzlichen Induktivität im Meßkreis, und
- Fig. 4: eine erfindungsgemäße Schaltungsanordnung auf einem Trägersubstrat in Dickfilmtechnik.

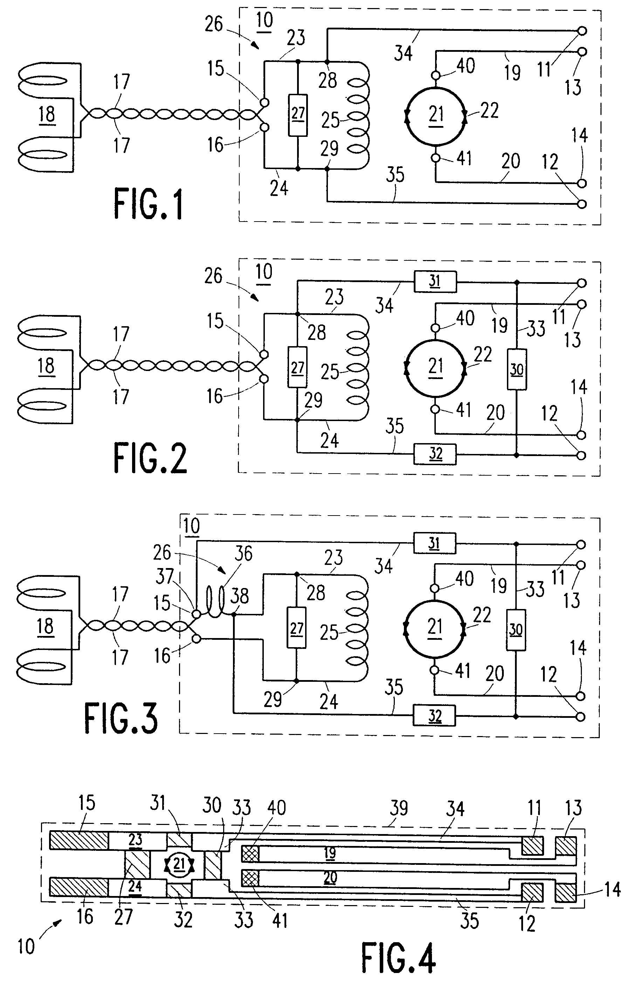

Fig. 1 zeigt eine erfindungsgemäße Schaltungsanordnung 10, die, mit einem SQUID und einer Einkoppelspule kompettiert, auch als SQUID-Modul bezeichnet ist. Die Schaltungsanordnung 10 ist einerseits mit einer nicht dargestellten elektronischen Regeleinrichtung verbunden, über einen ersten und zweiten sowie fünften und sechsten Kontaktpad 11 und 12 sowie 13 und 14, und andererseits über einen dritten und vierten Kontaktpad 15, 16 über Verbindungsleitungen 17 mit einem Gradiometer 18. Die Schaltungsanordnung 10 weist ferner eine sechste und siebte Verbindungsleitung 19, 20 auf, die einerseits mit dem eigentlichen SQUID 21, also dem SQUID-Ring mit Johnson-Kontakten 22 und andererseits mit den entsprechenden Kontaktpads 13 und 14 verbunden sind. Die Verbindungsleitungen 17 führen, wie bereits erwähnt, auf die Kontaktpads 15 und 16, die über eine dritte und vierte Verbindungsleitung 23, 24 mit einer Einkoppelspule 25 verbunden sind und einen Meßkreis 26 bilden. Die Endpunkte der Einkoppelspule 25 sind mit einem ersten Widerstand 27 zur Dämpfung verbunden.

Erfindungsgemäß kann vollständig auf eine im Stand der Technik erforderliche Modulationsspule verzichtet werden, indem die erste und zweite Verbindungsleitung direkt galvanisch mit dem Meßkreis in den Punkten 28 und 29 verbunden sind.

Fig. 2 zeigt eine weitere erfindungsgemäße Schaltungsanordnung 10, die gegenüber der in Fig. 1 dargestellten um einen zweiten, dritten und vierten Widerstand 30, 31 und 32 ergänzt ist. Der zweite Widerstand 30 ist in einer fünften, den ersten und zweiten Kontaktpad 11, 12 verbindenden Verbindungsleitung 33 angeordnet. Der dritte Widerstand 31 ist in der ersten Verbindungsleitung 34 und der vierte Widerstand 32 in der zweiten Verbindungsleitung 35 zwischengeschaltet. Diese Widerstände können mehrere Funktionen erfüllen.

Sie dienen einerseits als Leitungsabschluß, indem ihr Zusammenwirken etwa dem Wellenwiderstand der Leitung entspricht. Mit dem Widerstandsverhältnis des zweiten Widerstands 30 zum dritten oder vierten Widerstand 31 oder 32 kann die Reglerstromempfindlichkeit auf ein gewünschtes Maß reduziert werden. Denn eine zu feste Kopplung ergibt eine unerwünschte hohe Empfindlichkeit gegen Hochfrequenzfremdeinstrahlung.

Bei Bedarf können diese Widerstände 30, 31 und 32 auch gemeinsam zum Heizen genutzt werden, wobei wegen der optimalen weiter unten noch angegebenen örtlichen Platzierung zum SQUID an den entsprechenden ersten und zweiten Kontaktpads 11 und 12 nur eine Leistung von etwa 0,1 Ws (bei 2 V x 25 mA x 2s) benötigt wird. Die im Stand der Technik zum Heizen erforderlichen weiteren Verbindungsleitungen und Widerstände sind daher entbehrlich. Hier sei angemerkt, daß auch der im Meßkreis enthaltene erste Widerstand 27, der im wesentlichen der Dämpfung parasitärer Effekte dient, wie auch die genannten weiteren Widerstände 30, 31, 32 als gemeinsame Dickfilmschaltung realisiert sind.

Fig. 3 zeigt eine erfindungsgemäße Weiterbildung der Schaltungsanordnung 10 nach Fig. 1 bzw. Fig. 2. Durch diese Weiterbildung, die letztlich eine in den Meßkreis 26 eingebrachte zusätzliche Induktivität 36 mit den Endpunkten 37 und 38 betrifft, ist die erfindungsgemäße Schaltungsanordnung 10 auch für Anwendungen geeignet, bei denen absolute Rückwirkungsfreiheit gefordert wird, d.h. bei denen nicht nur der Fluß im SQUID-Ring 21, sondern auch der durch das externe Feld im Gradiometer 18 hervorgerufene Strom zu Null kompensiert werden muß. Die zusätzlich supraleitende Induktivität 36 ist erfindungsgemäß dann derart in den Meßkreis 26 einzuschalten, daß sie einerseits mit ihrem Anschluß 37 letztlich mit einer der Verbindungsleitungen 17 zum Gradiometer (18) weisend verbunden ist und andererseits mit ihrem Anschlußpunkt 38 mit der dritten Verbindungsleitung 23 verbunden ist. Am Anschlußpunkt 37 ist entsprechend dieser Ausgestaltung der Erfindung auch die erste Verbindungsleitung 34 und am Anschlußpunkt 38 die zweite Verbindungsleitung 35 galvanisch angeschlossen. Durch Einspeisen des Reglerstromes an den Endpunkten der Induktivität 36 wird der Strom außerhalb der Induktivität 36 kompensiert und in der Induktivität selbst erhöht, bis der gesamte Fluß in der Induktvität 36 konzentriert ist, da die Summe aller Flüsse konstant bleibt. Die Induktivität 36 darf jedoch erfindungsgemäß mit den übrigen Induktivitäten nicht magnetisch verkoppelt sein.

Fig. 4 zeigt eine erfindungsgemäße Schaltungsanordung 10, realisiert auf einer keramischen Trägerplatte 39, auf der sämtliche vier Widerstände 27, 30, 31 und 32 sowie sämtliche Kontaktpads 11, 12, 13, 14, 15, 16, 40 und 41 sowie sämtliche Verbindungsleitungen 19, 20, 23, 24, 33, 34 und 35 als Dickfilmschaltung direkt auf dem Keramiksubstrat 39 aufgebracht sind. Das Keramiksubstrat 39 ist ca. 25 mm x 4 mm x 0,6 mm und dient gleichzeitig, wie bereits erwähnt, als Trägerplättchen für die Einkoppelspule und den SQUID-Ring, der quadratische Abmessungen, wie ca. 3,5 mm x 3,5 mm x 0,5 mm aufweist. Der SQUID-Ring 21 wird, wie angedeutet, zentrisch zu den im Rechteck angeordneten vier Widerständen 27, 30, 31 und 32 platziert. Der SQUID-Ring kann als integralen Bestandteil die Einkoppelspule 25 und entsprechende Kontakte aufweisen, mit denen deren Enden mit der dritten und vierten Verbindungsleitung verbunden sind.

Aufgrund dieser erfindungsgemäßen Ausgestaltung sind, im Gegensatz zum Stand der Technik, weitere Anschlußleitungen oder Widerstände zum Heizen nicht erforderlich und da die vier Widerstände extrem nahe zum SQUID-Ring 21 lokalisiert sind, genügt auch ein kurzer Heizstromimpuls von wenigen Milliampere.

Die in der vorstehenden Beschreibung, in den Fig. 1, 2, 3 und 4 sowie in den Ansprüchen offenbarten Merkmale der Erfindung können sowohl einzeln als auch in beliebiger Kombination für die Verwirklichung der Erfindung in ihren verschiedenen Ausführungsformen wesentlich sein.

## Patentansprüche

1. Schaltungsanordnung zum Betrieb eines SQUID's, insbesondere eines DC-SQUID's mit einer Einkoppelspule in einem bedämpften Meßkreis, mindestens einem Widerstand, Verbindungsleitungen und Kontaktpads zum Anschluß des SQUID's, eines Gradiometers und einer Regelelektronik,
dadurch gekennzeichnet, daß eine erste und eine zweite Verbindungsleitung (34, 35) zwischen dem Meßkreis (26) und einem ersten und zweiten Kontaktpad (11, 12) zum Anschluß mindestens des Ausgangssignals der Regelelektronik und zum galvanischen Einkoppeln des von dieser bereitgestellten integrierten Reglerstroms vorgesehen sind, wobei das SQUID-Signal als Eingangssignal der Regelelektronik über einen fünften und sechsten Kontaktpad (13, 14) zur Verfügung steht.

2. Schaltungsanordnung nach Anspruch 1,
dadurch gekennzeichnet, daß der Meßkreis (26) eine Einkoppelspule (25) enthält und deren Enden über eine dritte und vierte Verbindungsleitung (23, 24) mit einem dritten und vierten Kontaktpad (15, 16) verbunden sind zum Anschluß des Gradiometers (18) über Verbindungsleitungen (17), und daß zwischen der dritten und vierten Verbindungsleitung (23, 24) ein erster Widerstand (27) angeordnet ist.

3. Schaltungsanordnung nach Anspruch 2,
dadurch gekennzeichnet, daß die erste und dritte Verbindungsleitung (35, 24) sowie die zweite und vierte Verbindungsleitung (35, 24) miteinander in den Verbindungspunkten (28, 29) galvanisch verbunden sind.

4. Schaltungsanordnung nach Anspruch 2,
dadurch gekennzeichnet, daß eine supraleitende Induktivität (36) zwischen dem dritten Kontaktpad (15) und der dritten Verbindungsleitung (23) zwischengeschaltet ist, und daß die erste Verbindungsleitung (34) mit dem dritten Kontaktpad (15) und die zweite Verbindungsleitung (35) mit der dritten Verbindungsleitung (23) galvanisch verbunden ist, und daß die Induktivität (36) derart angeordnet ist, daß sie mit keiner weiteren Induktivität des SQUID-Moduls magnetisch gekoppelt ist.

5. Schaltungsanordnung nach einem oder mehreren der vorhergehenden Ansprüche,
dadurch gekennzeichnet, daß der erste und zweite Kontaktpad (11, 12) über eine fünfte einen zweiten Widerstand (30) enthaltende Verbindungsleitung (33) miteinander verbunden sind, und daß ein dritter Widerstand (31) in der ersten Verbindungsleitung (34) und ein vierter Widerstand (32) in der zweiten Verbindungsleitung (35) angeordnet ist.

6. Schaltungsanordnung nach Anspruch 5,
dadurch gekennzeichnet, daß zusammenwirkend der zweite, dritte und vierte Widerstand (30, 31, 32) als Leitungsabschluß ausgelegt sind und etwa dem Wellenwiderstand der Leitung entsprechen.

7. Schaltungsanordnung nach Anspruch 6,
dadurch gekennzeichnet, daß das Verhältnis des zweiten Widerstands (30) zum dritten oder vierten Widerstand (31, 32) die Modulationsstromempfindlichkeit bestimmt.

8. Schaltungsanordnung nach einem oder mehreren der vorhergehenden Ansprüche,
dadurch gekennzeichnet, daß der zweite, aber auch der dritte und vierte Widerstand (30, 31, 32) in einer vom Messen unabhängigen Heizfunktion ferner derart bemessen und zum SQUID (21) weisend angeordnet sind, daß bei einer Leistung von nur ca. 0,1 Ws, eingespeist über die ersten und zweiten Kontaktpads (11, 12), kurzzeitig die Sprungtemperatur des supraleitenden Materials überschritten wird.

9. Schaltungsanordnung nach einem oder mehreren der vorhergehenden Ansprüche,
dadurch gekennzeichnet, daß die Einkoppelspule (25), alle vier Widerstände (27, 30, 31, 32), alle Verbindungsleitungen (19, 20, 23, 24, 33, 34, 35) und alle Kontaktpads (11, 12, 13, 14, 15, 16, 40, 41), inklusive eines weiteren fünften, sechsten, siebten und achten Kontaktpad (13, 14, 40, 41) und einer sechsten und siebten Verbindungsleitung (19, 20) zum Anschluß und Kontaktieren des SQUID-Rings (21) als Dickfilmschaltung auf einem nur einige Millimeter breiten, wenige Zentimeter langen und unter einem Millimeter dicken Keramiksubstrat angeordnet ist, daß gleichzeitig das Trägerplättchen (39) für das SQUID-Modul (10) bildet.

10. Schaltungsanordnung nach Anspruch 9,
dadurch gekennzeichnet, daß der SQUID-Ring (21) zentrisch zu den im Rechteck angeordneten vier Widerständen (27, 30, 31, 32) montiert ist.

11. Schaltungsanordnung nach Anspruch 10,
dadurch gekennzeichnet, daß der SQUID-Ring (21) als integralen Bestandteil die Einkoppelspule (25) und entsprechende Kontakte aufweist, mit denen deren Enden mit der dritten und vierten Verbindungsleitung (23, 24) verbunden sind.
